# EUROPEAN PATENT APPLICATION

(11) **EP 2 590 491 A2**
(43) Date of publication of application: **08.05.2013**
(21) Application number: 11195248.7
(22) Date of filing: 22.12.2011
(51) Int. Cl.: H05K 7/20, H01L 23/373

(54) **Heat management device and electronic apparatus**

(30) Priority: 04.11.2011 TW 100140442
(71) Applicant: Most Energy Corporation, Luzhu Township, Taoyuan County (TW)
(72) Inventor: Lai, Ming-Hsiung, 302 Zhubei City, Hsinchu County (TW); Jiang, Yu-Hsiang, 235 Zhonge Dist., New Taipei City (TW); Chen, You-Chi, 406 Beitun Dist., Taichung City (TW)
(74) Representative: 2K Patentanwälte Blasberg Kewitz & Reichel

(57) **Abstract**

An electronic apparatus (2; 3-7) includes a heat dissipating module (21; 51,61,71) and an electronic device (22). The heat dissipating module includes a base (211) and a plurality of heat dissipating layers (212). The heat dissipating layers are formed on a surface of the base in sequence. Each heat dissipation layer has at least one heat dissipating structure, and the heat dissipation structure (H) has a heat storage/dissipation area (A1) and a heat conductive area (A2). The heat storage/dissipation area surrounds the heat conductive area, and a gap is configured between the heat storage/dissipation area and the heat conductive area. The electronic device (22) is attached to the heat dissipating module. A heat management device is also disclosed.

## Description

### BACKGROUND OF THE INVENTION

### FIELD OF INVENTION

The present invention relates to a heat management device and an electronic apparatus.

### RELATED ART

Due to the great progress of economy and improvement of life quality, the requirement of energy becomes more and more important. However, since the importance of environmental protection has been noticed recent years, it is desired to develop other power resource such as recyclable energy technologies. At present, the most popular one is the solar energy power system. In general, the solar energy power system includes the heat power system and the photovoltaic power system. Regarding to the photovoltaic power system, it is mainly composed of a condensing lens and a photovoltaic chip. The configuration of the condensing lens can concentrate the light energy on the photovoltaic chip for generating electricity.

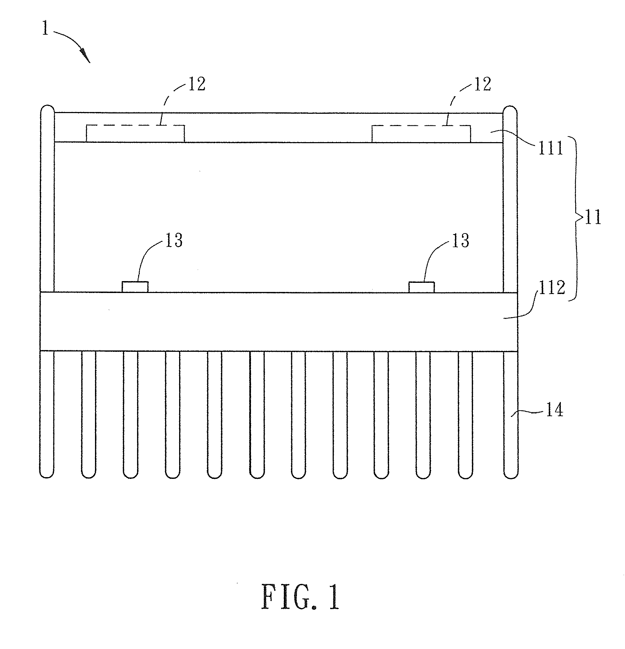

FIG. 1 is a schematic diagram showing a conventional photovoltaic power apparatus 1, which includes a frame 11, a condensing lens set 12, two photovoltaic chips 13, and a heat dissipating device 14. The condensing lens set 12 is installed on a first supporting portion 111 of the frame 11 for receiving the solar light. The photovoltaic chips 13 are installed on a second supporting portion 112 of the frame 11, and they are located corresponding to the condensing lens set 12 for receiving the light passing through the condensing lens set 12 and performing the photoelectric conversion. The heat dissipating device 14 is attached to one side of the second supporting portion 112 of the frame 11 opposite to the photovoltaic chips 13 for dissipating the heat generated by the internal components.

In the conventional photovoltaic power apparatus 1, the heat dissipation is conducted only through the heat dissipating device 14 as well as its fins, so that the heat dissipation efficiency is not uniform. In addition, the high temperature environment may sufficiently affect the characteristics of the electronic components in the electronic apparatus, and moreover, the extreme high temperature may cause the permanent damage of the electronic components.

Therefore, it is an important subject of the present invention to provide a heat management device and an electronic apparatus that can uniformly dissipate the generated heat so as to improve the heat dissipation efficiency.

### SUMMARY OF THE INVENTION

In view of the foregoing subject, an object of the present invention is to provide a heat management device and an electronic apparatus that can uniformly dissipate the generated heat so as to improve the heat dissipation efficiency.

To achieve the above object, the present invention discloses an electronic apparatus including a heat dissipating module and an electronic device. The heat dissipating module includes a base and a plurality of heat dissipating layers. The heat dissipating layers are formed on a surface of the base in sequence. Each heat dissipation layer has at least one heat dissipating structure, and the heat dissipation structure has a heat storage/dissipation area and a heat conductive area. The heat storage/dissipation area surrounds the heat conductive area, and a gap is configured between the heat storage/dissipation area and the heat conductive area. The electronic device is attached to the heat dissipating module.

In one embodiment of the present invention, the heat storage-dissipation area comprises a plurality of non-metal particles, and the non-metal particles are graphite particles.

In one embodiment of the present invention, the heat conductive area comprises a plurality of metal particles, and the metal particles comprises copper, aluminum, gold, silver, tungsten, or their alloys.

In one embodiment of the present invention, the ratio of the size of the heat conductive area to the size of the heat storage/dissipation area is between 1:1.25 and 1:2.5.

In one embodiment of the present invention, the ratio of the gap to the circumference of the heat storage/dissipation area is between 0.01:1 1 and 0.15:1.

In one embodiment of the present invention, the heat storage/dissipation areas of adjacent two of the heat dissipating layers contact with each other, while the heat conductive areas of adjacent two of the heat dissipating layers contact with each other.

In one embodiment of the present invention, the electronic apparatus further includes a heat spreading module attached to the electronic device.

In one embodiment of the present invention, the heat spreading module is a porous metallic heat spreader, a vapor chamber heat spreader, or a vapor chamber porous heat spreader.

In one embodiment of the present invention, the electronic apparatus further includes a thermoelectric conversion element attached to the heat spreading module or the heat dissipating module.

In one embodiment of the present invention, the electronic device is a photovoltaic power device or a light-emitting device.

To achieve the above object, the present invention also discloses a heat management device cooperated with an electronic device. The heat management device includes a heat dissipating module and a heat spreading module. The heat dissipating module includes a base and a plurality of heat dissipating layers, which are formed on a surface of the base in sequence. Each heat dissipation layer has at least one heat dissipating structure, and the heat dissipation structure has a heat storage/dissipation area and a heat conductive area. The heat storage/dissipation area surrounds the heat conductive area, and a gap is configured between the heat storage/dissipation area and the heat conductive area. The heat dissipating module and the heat spreading module are attached to the electronic device.

In one embodiment of the present invention, the heat spreading module is a porous metallic heat spreader, a vapor chamber heat spreader, or a vapor chamber porous heat spreader.

In one embodiment of the present invention, the heat storage-dissipation area comprises a plurality of non-metal particles, and the non-metal particles are graphite particles.

In one embodiment of the present invention, the heat conductive area comprises a plurality of metal particles, and the metal particles comprises copper, aluminum, gold, silver, tungsten, or their alloys.

In one embodiment of the present invention, the ratio of the gap to the circumference of the heat storage/dissipation area is between 0.01:1 and 0.15:1.

In one embodiment of the present invention, the heat management device further includes a thermoelectric conversion element attached to the heat spreading module or the heat dissipating module.

As mentioned above, the heat management device and electronic apparatus of the present invention include a plurality of heat dissipating layers formed on the base in sequence. In the heat dissipating layer, the heat storage/dissipation area surrounds the heat conductive area, and a gap is configured between the heat storage/dissipation area and the heat conductive area. This configuration can enhance the heat transmission efficiency, so that the heat generated from the heat source can be transferred to every heat dissipating layer. Accordingly, the generated heat can be uniformly dissipated so as to improve the heat dissipation efficiency.

### BRIEF DESCRIPTION OF THE DRAWINGS

The invention will become more fully understood from the detailed description and accompanying drawings, which are given for illustration only, and thus are not limitative of the present invention, and wherein:

FIG. 1 is a schematic diagram showing a conventional photovoltaic power apparatus;

FIG. 2A is a schematic diagram showing an electronic apparatus according to a preferred embodiment of the present invention;

FIG. 2B is a schematic diagram showing a heat dissipating module of the electronic apparatus according to the preferred embodiment of the present invention;

FIG. 3 is a schematic diagram showing another electronic apparatus according to the preferred embodiment of the present invention;

FIG. 4 is a schematic diagram showing another electronic apparatus according to the preferred embodiment of the present invention;

FIG. 5 is a schematic diagram showing another electronic apparatus according to the preferred embodiment of the present invention;

FIG. 6 is a schematic diagram showing another electronic apparatus according to the preferred embodiment of the present invention; and

FIG. 7 is a schematic diagram showing another electronic apparatus according to the preferred embodiment of the present invention.

### DETAILED DESCRIPTION OF THE INVENTION

The present invention will be apparent from the following detailed description, which proceeds with reference to the accompanying drawings, wherein the same references relate to the same elements.

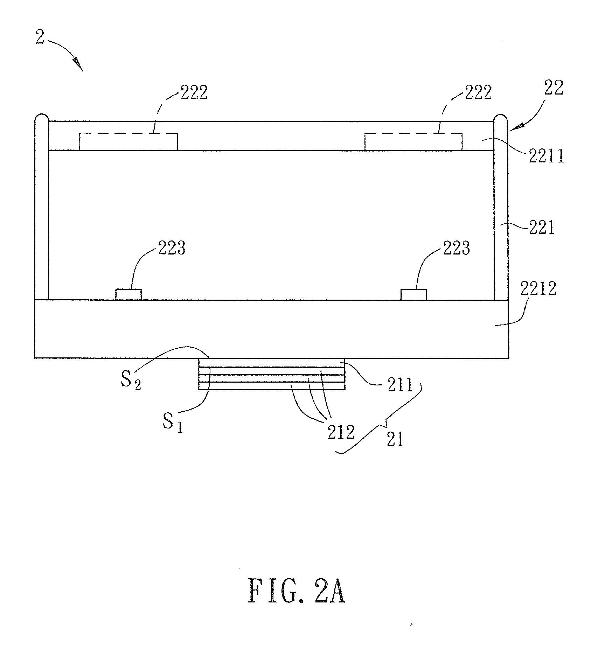

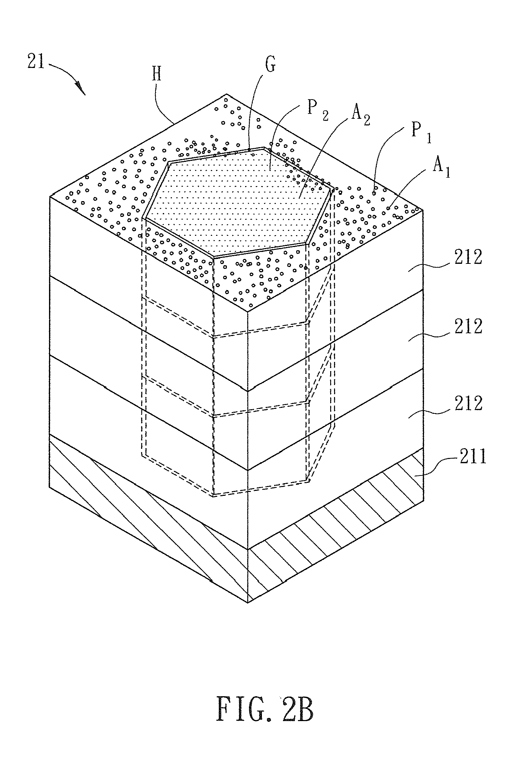

FIGS. 2A and 2B are schematic diagrams showing an electronic apparatus 2 according to a preferred embodiment of the present invention. Referring to FIGS. 2A and 2B, the electronic apparatus 2 includes a heat dissipating module 21 and an electronic device 22. The heat dissipating module 21 includes a base 211 and three heat dissipating layers 212. The base 211 has a first surface S₁ and a second surface S₂ disposed opposite to each other. The heat dissipating layers 212 are formed on the first surface S₁ of the base 211 in sequence. In other words, the heat dissipating layers 212 are stacked on the first surface S₁.

In practice, the base 211 can be made of a metal including copper, aluminum, gold, silver, tungsten, or their alloys. Besides, the area and thickness of the base 211 can be adjustable according to the size and generated heat of the heat source (the electronic device 22). Preferably, the thickness of the base 211 is between 100µm and 1000µm.

In this embodiment, the heat dissipating module 21 includes three heat dissipating layers 212. To be noted, depending on the requirement and design of the product, the heat dissipating module 21 may include other numbers of heat dissipating layers 212. Preferably, the heat dissipating module 21 includes 3-15 heat dissipating layers 212.

One side of the electronic device 22 is attached to the second surface S₂ of the base 211 of the heat dissipating module 21. In this embodiment, the electronic device 22 is a photovoltaic power device, which includes a frame 221, a condensing lens set 222, and two photovoltaic chips 223. The condensing lens set 222 is installed on a first supporting portion 2211 of the frame 221 for receiving the solar light. The photovoltaic chips 223 are installed on a second supporting portion 2212 of the frame 221, and they are located corresponding to the condensing lens set 222 for receiving the light passing through the condensing lens set 222 and performing the photoelectric conversion.

To be noted, the electronic device 22 is, for example but not limited to, a photovoltaic power device. In practice, the electronic device 22 can be a light-emitting device, power device, display card, motherboard, lamp, or other electronic devices or products that can generate heat during operation. In addition, the dimension relationship (scales) of the base 211 and heat dissipating layers 212 of the heat dissipating module 21 as well as the components in the electronic device 22 as shown in FIG. 2A are used for illustration only, and the actual dimensions thereof can be different.

The heat dissipating module 21 of the present invention will be further described with reference to FIG. 2B, the heat dissipating layer 212 of the heat dissipating module 21 includes a heat dissipating structure H, which includes a heat storage/dissipation area A₁ and a heat conductive area A₂. The heat storage/dissipation area A₁ surrounds the heat conductive area A₂, and a gap G is configured between the heat storage/dissipation area A₁ and the heat conductive area A₂.

The heat storage/dissipation area A₁ of the heat dissipating structure H includes a plurality of non-metal particles P₁ and a polymer gel. The non-metal particles P₁ can be graphite particles, and the polymer gel can be a light-cured gel or a thermosetting gel. In this embodiment, the polymer gel is PMMA (polymethly methacrylate). In practice, the purity of the graphite particle is between 97% and 99.9%, and the diameter of the graphite particle is between 500µm and 3000µm. Since the graphite has excellent thermal conductivity, especially on the plane composed of X-axis and Y-axis, the heat storage/dissipation area A₁ containing the graphite particles can provide high-performance thermal transmission along the horizontal direction of the heat dissipating layer 212.

The heat conductive area A₂ of the heat dissipating structure H includes a plurality of metal particles P₂ and a polymer gel. The metal particles P₂ can include copper, aluminum, gold, silver, tungsten, or their alloys, and the polymer gel can be a light-cured gel or a thermosetting gel. In this embodiment, the polymer gel is PMMA (polymethly methacrylate). Since the metal particles P₂ has better thermal conductivity in the vertical direction (Z-axis), the heat conductive area A₂ containing the metal particles P₂ can provide high-performance thermal transmission along the vertical direction of the heat dissipating layer 212. In practice, the ratio of the size of the heat conductive area A₂ to the size of the heat storage/dissipation area A₁ is between 1:1.25 and 1:2.5.

To be noted, the weight percentages of the non-metal particles P₁ and the metal particles P₂ can be modified according to the actual requirement. In addition, the heat storage/dissipation areas A₁ of two adjacent heat dissipating layers 212 are vertically contact with each other, while the heat conductive areas A₂ of two adjacent heat dissipating layers are vertically contact with each other. In this case, the heat storage/dissipation areas A₁ or the heat conductive areas A₂ can contact partially or entirely. In this embodiment, each heat dissipating layer 212 includes, for example, one heat dissipating structure H. However, depending on the requirement and design of the product, each heat dissipating layer 212 may include one or more heat dissipating structures H. Preferably, each heat dissipating layer 212 includes 50-750 heat dissipating structures H per square inch.

The gap G of the heat dissipating structure H is configured as the buffer for the thermal expansion of the heat storage/dissipation area A₁ and the heat conductive area A₂, so that the heat storage/dissipation area A₁ and the heat conductive area A₂ can closely attach to each other as the heat dissipating structure H is heated. This configuration can enhance the thermal conduction and heat dissipation of the heat dissipating structure H. Preferably, regarding to the size of the gap G, the ratio of the gap G to the circumference of the heat storage/dissipation area A₁ is between 0.01:1 and 0.15:1. Alternatively, since the expansion of different materials under the heating environment may vary, the size of the gap G is preferably modified with respect to different materials.

According to the above configurations, the generated heat can be conducted with high performance on the XY plane through the heat storage/dissipation areas A₁ of the heat dissipating module, and be efficiently transmitted vertically (Z-axis) through the heat conductive areas A₂. Therefore, the heat can be uniformly dissipated so as to improve the heat-dissipating effect.

In addition, the shape (from the top view) of the heat storage/dissipation area A₁ and the heat conductive area A₂ of the heat dissipating module 21 can be circle, ellipse, regular polygon, or irregular polygon. Besides, the shapes of the heat storage/dissipation area A₁ and the heat conductive area A₂ can be the same or different. Herein, the polygon includes, for example, 3 to 10 sides.

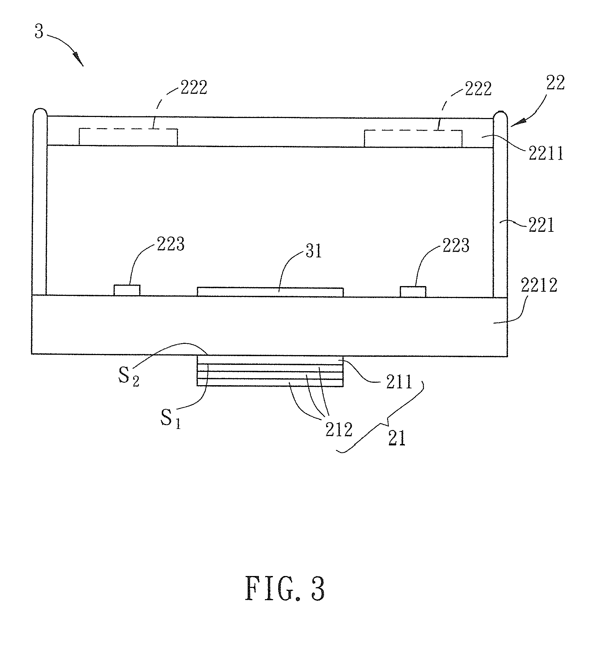

FIG. 3 is a schematic diagram showing another electronic apparatus 3 according to the preferred embodiment of the present invention. The difference between the electronic apparatuses 2 and 3 is in that the electronic apparatus 3 further includes a heat spreading module 31. In this embodiment, the heat spreading module 31 is attached to one side of the electronic device 22, which is opposite to the heat dissipating module 21. In practice, the heat spreading module 31 is a porous metallic heat spreader, a vapor chamber heat spreader, or a vapor chamber porous heat spreader. The porous metallic heat spreader is, for example, made of aluminum, copper, silver or other metals with higher heat transfer coefficient. In addition, the position of the heat spreading module 31 can be changed depending on the actual requirement. For example, the heat spreading module 31 may be adhered to the heat dissipating layer 212 of the heat dissipating module 21 through a thermal conductive adhesive so as to be attached to the electronic device 22 indirectly. Of course, the shape and dimension of the heat spreading module 31 can also be adjustable according to the actual requirement. By integrating the heat spreading module 31 and the heat dissipating module 21, the heat transmission efficiency in the vertical direction can be improved. Besides, the heat spreading module 31 can further make the conduction of the heat more uniform, thereby further enhancing the heat dissipation efficiency.

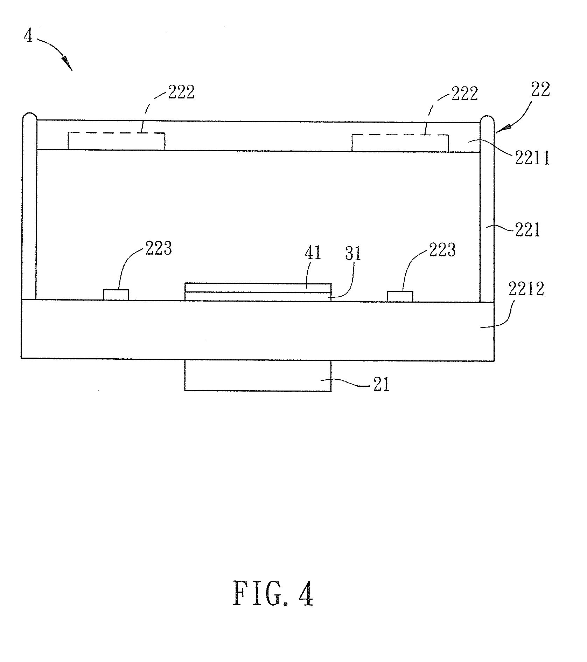

FIGS.4 to 7 are schematic diagrams showing different aspects of the electronic apparatus according to the preferred embodiment of the present invention. Referring to FIG. 4, the difference between the electronic apparatuses 3 and 4 is in that the electronic apparatus 4 further includes a thermoelectric conversion element 41. In this embodiment, the thermoelectric conversion element 41 is attached to one side of the heat spreading module 31. The thermoelectric conversion element 41 can be a thermoelectric generator (TEG) or a thermoelectric generating module (TEM). Accordingly, the thermoelectric conversion element 41 can receive the heat from the heat spreading module 31 and then generate additional electricity. If the electrodes of the thermoelectric conversion element 41 are electrically connected to the electronic device 22 (e.g. a photovoltaic power device), the total generated electricity can be increased.

Alternatively, if the electronic device 22 is other kind of electronic device or module, it is also possible to apply the additional electricity from the thermoelectric conversion element 41 to the electronic device 22 for driving it. Accordingly, the redundant heat can be effective recycled. By using the above configuration, the generated heat can be transmitted toward the desired direction, and can be recycled. Therefore, the operating electronic device 22 can achieve heat stable and heat balance so as to improve the stability and lifetime of the electronic device 22 as well as the internal components thereof.

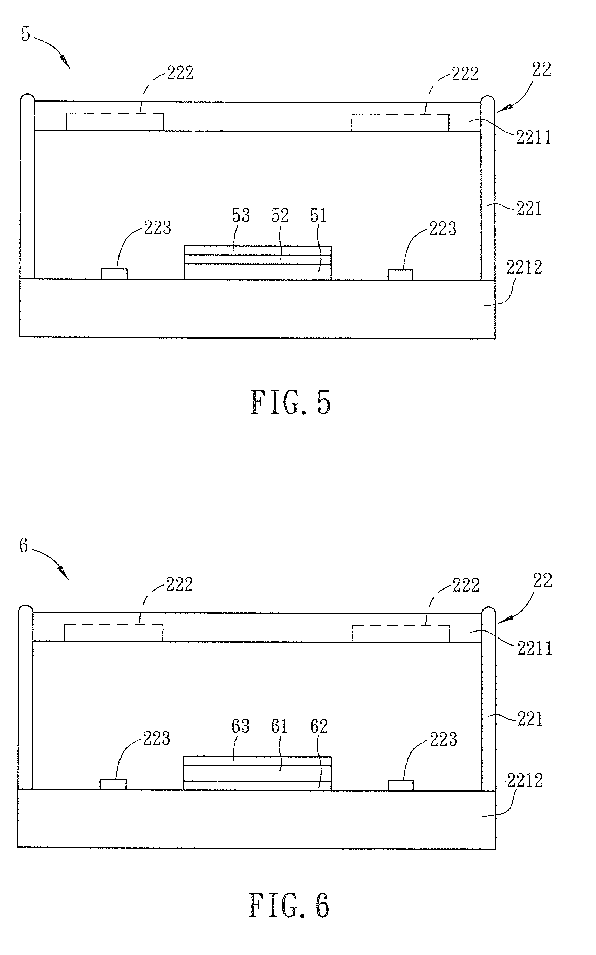

Referring to FIG. 5, the difference between the electronic apparatuses 5 and 4 is in that the heat dissipating module 51, the heat spreading module 52 and the thermoelectric conversion element 53 of the electronic apparatus 5 are attached to the second supporting portion 2212 in sequence. That is, the heat spreading module 52 is indirectly connected to the electronic device 22 through the heat dissipating module 51, and the heat spreading module 52 is located between the heat dissipating module 51 and the thermoelectric conversion element 53. Referring to FIG. 6, the difference between the electronic apparatuses 6 and 5 is in that the heat spreading module 62, the heat dissipating module 61, and the thermoelectric conversion element 63 of the electronic apparatus 6 are attached to the second supporting portion 2212 in sequence. That is, the heat dissipating module 61 is indirectly connected to the electronic device 22 through the heat spreading module 62, and the heat dissipating module 61 is located between the heat spreading module 62 and the thermoelectric conversion element 63.

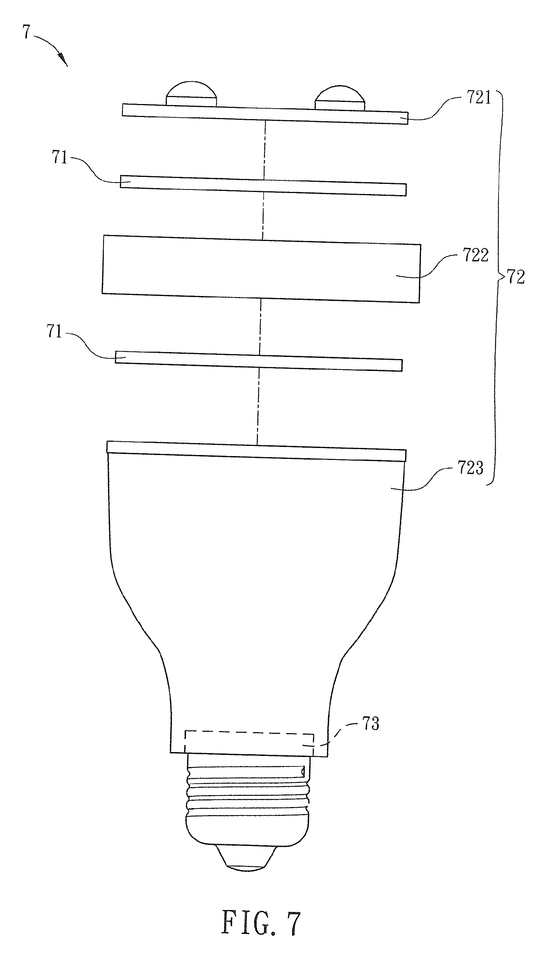

With reference to FIG. 7, the electronic device 72 of the electronic apparatus 7 is a light-emitting device, which includes light-emitting diodes (LED) as the light source. The electronic device 72 includes a light-emitting module 721, a carrying substrate 722, and a casing 723. In this case, the light-emitting module 721 is disposed on the carrying substrate 722, and the carrying substrate 722 is assembled within the casing 723.

In this embodiment, the electronic apparatus 7 is configured with two heat dissipating modules 71 for enhancing the heat dissipation effect. One of the heat dissipating modules 71 is disposed between the light-emitting module 721 and the carrying substrate 722, while the other one is attached to the other side of the carrying substrate 722. Besides, the heat spreading module 73 is attached to the casing 723.

In practice, the electronic apparatus can be optionally configured with different numbers of heat dissipating modules and heat spreading modules depending on the heat generated by the heat source. Similarly, the positions of the heat dissipating module and heat spreading module can be changed.

In addition, the present invention also discloses a heat management device cooperated with an electronic device. The heat management device includes a heat dissipating module and a heat spreading module. The heat dissipating module includes a base and a plurality of heat dissipating layers, which are formed on a surface of the base in sequence. Each heat dissipation layer has at least one heat dissipating structure, and the heat dissipation structure has a heat storage/dissipation area and a heat conductive area. The heat storage/dissipation area surrounds the heat conductive area, and a gap is configured between the heat storage/dissipation area and the heat conductive area. The heat dissipating module and the heat spreading module are attached to the electronic device.

To be noted, the features and functions of the heat dissipating module and heat spreading module in the heat management device are all the same as those of the heat dissipating modules 21, 51, 61, 71 and the heat spreading modules 31, 52, 62, 72 of FIGS. 3 to 7, so the detailed descriptions thereof will be omitted.

According to the above, there is disclosed an electronic apparatus 2; 3-7 including a heat dissipating module 21; 51,61,71 and an electronic device 22. The heat dissipating module includes a base 211 and a plurality of heat dissipating layers 212. The heat dissipating layers are formed on a surface of the base in sequence. Each heat dissipation layer has at least one heat dissipating structure, and the heat dissipation structure H has a heat storage/dissipation area A1 and a heat conductive area A2. The heat storage/dissipation area surrounds the heat conductive area, and a gap is configured between the heat storage/dissipation area and the heat conductive area. The electronic device 22 is attached to the heat dissipating module. A heat management device is also disclosed.
In summary, the heat management device and electronic apparatus of the present invention include a plurality of heat dissipating layers formed on the base in sequence. In the heat dissipating layer, the heat storage/dissipation area surrounds the heat conductive area, and a gap is configured between the heat storage/dissipation area and the heat conductive area. This configuration can enhance the heat transmission efficiency, so that the heat generated from the heat source can be transferred to every heat dissipating layer. Accordingly, the generated heat can be uniformly dissipated so as to improve the heat dissipation efficiency.

Although the invention has been described with reference to specific embodiments, this description is not meant to be construed in a limiting sense. Various modifications of the disclosed embodiments, as well as alternative embodiments, will be apparent to persons skilled in the art. It is, therefore, contemplated that the appended claims will cover all modifications that fall within the true scope of the invention.

## Claims

1. An electronic apparatus (2; 3-7), comprising:
a heat dissipating module (21; 51,61,71) comprising a base (211) and a plurality of heat dissipating layers (212), wherein the heat dissipating layers are formed on a surface of the base in sequence, each of the heat dissipation layers has at least one heat dissipating structure, the heat dissipation structure (H) has a heat storage/dissipation area (A1) and a heat conductive area (A2), the heat storage/dissipation area surrounds the heat conductive area, and a gap is configured between the heat storage/dissipation area and the heat conductive area; and
an electronic device (22) attached to the heat dissipating module.

2. The electronic apparatus of claim 1, wherein the heat storage-dissipation area (A1) comprises a plurality of non-metal particles, and the non-metal particles are graphite particles.

3. The electronic apparatus of claim 1 or 2, wherein the heat conductive area (A2) comprises a plurality of metal particles, and the metal particles comprises copper, aluminum, gold, silver, tungsten, or their alloys.

4. The electronic apparatus of one of the preceding claims, wherein the ratio of the size of the heat conductive area (A2) to the size of the heat storage/dissipation area (A1) is between 1:1.25 and 1:2.5.

5. The electronic apparatus of one of the preceding claims, wherein the ratio of the gap to the circumference of the heat storage/dissipation area (A1) is between 0.01:1 and 0.15:1.

6. The electronic apparatus of one of the preceding claims, wherein the heat storage/dissipation areas (A1) of adjacent two of the heat dissipating layers (212) contact with each other, while the heat conductive areas (A2) of adjacent two of the heat dissipating layers (212) contact with each other.

7. The electronic apparatus one of the preceding claims, further comprising:
a heat spreading module (31; 52,62,72) attached to the electronic device (22).

8. The electronic apparatus of claim 7, wherein the heat spreading module (31; 52,62,72) is a porous metallic heat spreader, a vapor chamber heat spreader, or a vapor chamber porous heat spreader.

9. The electronic apparatus of claim 7 or 8, further comprising:
a thermoelectric conversion element (41) attached to the heat spreading module (31; 52,62,72) or the heat dissipating module (21; 51,61,71).

10. The electronic apparatus one of the preceding claims, wherein the electronic device (22) is a photovoltaic power device or a light-emitting device.

11. A heat management device cooperated with an electronic device (22), comprising:
a heat dissipating module (21; 51,61,71) comprising a base (211) and a plurality of heat dissipating layers (212), wherein the heat dissipating layers are formed on a surface of the base (211) in sequence, each of the heat dissipation layers has at least one heat dissipating structure, the heat dissipation structure (H) has a heat storage/dissipation area (A1) and a heat conductive area (A2), the heat storage/dissipation area surrounds the heat conductive area, and a gap is configured between the heat storage/dissipation area and the heat conductive area; and
a heat spreading module (31; 52,62,72), wherein the heat dissipating module and the heat spreading module are attached to the electronic device (22).

12. The heat management device of claim 11, wherein the heat storage-dissipation area (A1) comprises a plurality of non-metal particles, and the non-metal particles are graphite particles.

13. The heat management device of claim 11 or 12, wherein the heat conductive area (A2) comprises a plurality of metal particles, and the metal particles comprises copper, aluminum, gold, silver, tungsten, or their alloys.

14. The heat management device of one of the claims 11 to 13, wherein the ratio of the gap to the circumference of the heat storage/dissipation area (A1) is between 0.01:1 and 0.15:1.

15. The heat management device of one of the claims 11 to 14, further comprising:
a thermoelectric conversion element attached to the heat spreading module (31; 52,62,72) or the heat dissipating module (21; 51,61,71).
